# EUROPÄISCHE PATENTANMELDUNG

(11) **EP 4 177 035 A1**
(43) Veröffentlichungstag der Anmeldung: **10.05.2023**
(21) Anmeldenummer: 22202653.6
(22) Anmeldetag: 20.10.2022
(51) Int. Cl.: B29C 45/00, H01H 9/02, B29K 69/00, B29L 31/34

(54) **BRUCHSTABILE ELEKTRISCHE FERNBEDIENUNG**

(30) Priorität: 21.10.2021 DE 102021127425
(71) Anmelder: FM Marketing GmbH, 5202 Neumarkt am Wallersee (AT)
(72) Erfinder: Maier, Ferdinand, 5202 Schalkham 77, Neumarkt am Wallersee (AT)
(74) Vertreter: von Bülow & Tamada

(57) **Zusammenfassung**

Eine Fernbedienung zur Bedienung eines elektronischen Geräts umfassend ein Kunststoffgehäuse mit einem Kunststoffplattensegment mit einem Bedienfeld, welches zumindest ein Bedienelement, vorzugsweise Tastenelemente und/oder zumindest ein Steuerkreuz zur Bedienung eines elektronischen Geräts aufweist,
wobei das Kunststoffplattensegment aus einem Kunststoffmaterial eine Kerbschlagzähigkeit nach Charpy von mehr als 6 kJ/m², insbesondere von 9,0 kJ/m² +/- 0,3 kJ/m², aufweist,
wobei das Kunststoffmaterial als ein isosorbid-basiertes Polymer ausgebildet ist.

## Beschreibung

Die vorliegende Erfindung betrifft eine bruchstabile elektrische Fernbedienung nach dem Oberbegriff des Anspruchs 1.

Fernbedienungen sind an sich aus dem Alltag bekannt. Sie können genutzt werden um elektronische Geräte, z.B. Fernseher, Radio, Klimageräte oder dergleichen zu steuern. Die Signalübertragung kann durch Aussenden eines Steuersignals erfolgen, wobei sowohl Funksignale nach dem Bluetooth-Low-Energy-Standard ebenso eingesetzt werden wie optische Signale (z.B. Infrarot). Einer oder mehrere Signalgeber für beide Signalarten können auch vorteilhaft in einer Fernbedienung integriert sein. Damit ist u.a. auch eine bidirektionale Kommunikation möglich.

Nachteilig im Alltagsgebrauch ist der Bruch von Kunststoffgehäusen bei derartigen elektrischen Fernbedienungen. Um dies zu verbessern, wurden bislang verschiedene Kunststoffe eingesetzt. Beispielsweise weist PMMA eine große Schwankungsbreite in der Kerbschlagzähigkeit auf, viele PMMA-Verbindungen sind nur im geringen Maße kratzfest. PMMA-Kunststoffe mit hoher Kerbschlagzähigkeit weisen zugleich eine geringe Bruchdehnung als Maßstab der plastischen Verformung z.B. von 5% auf. Dies bedeutet, dass das Material nur gering verformbar ist. Ein mechanischer Stoß auf das Material wird daher nicht durch eine Verformung gedämpft. Übliche Polycarbonate weisen ebenfalls eine Bruchdehnung von weniger als 50% auf.

Isosorbidbasierte Polymere werden als Lacke oder in der Innenverkleidung von Automobilen eingesetzt. Mechanische Schocks, wie sie beim Fallenlassen von Fernbedienungen auftreten treten dabei nicht auf, da diese Bauteile fest verbaut sind.

Auch die Exposition von KfZ-Bauteilen von Fetten oder Schweiß treten in diesem Bereich nicht auf bzw. lediglich beim Lenkrad, welches üblicherweise aus anderen Materialien wie z.B. Kunstleder ausgerüstet sind.

Zur Gewährleistung der Dichtigkeit und des Schutzes der Elektronik von Feuchtigkeit und anderen Einflüssen sollte das Kunststoffgehäuse allerdings, bevor es zu einem Bruch kommt, idealerweise durch eine plastische Verformung auf eine übermäßige mechanische Belastung reagieren.

Weiter bevorzugt, sowohl für die Signalübertragung im Fall einer optischen Signalübertragung, als auch für die optische Erscheinung ist der Lichttransmissionsgrad. PMMA weist hierbei eine ideale Transparenz und Brillanz auf.

Herkömmliche Polycarbonate und viele andere Kunststoffe weisen zudem eine geringe Stabilität gegenüber Fettsäuren auf. Handcremes und andere Fette auf der Haut können durch Diffusion in die Polymere eindringen und dort eine Eintrübung oder einen Fettglanz verursachen. Dieser Effekt kann nicht durch Reinigung entfernt werden.

Gleiches gilt für Salzlösungen und andere Elektrolytlösungen wie z.B. Schweiß. Üblicherweise treten Kunststoffe nicht in dauerhafter Exposition mit Schweiß und Fetten. Eine Ausnahme bilden hier Fernbedienungen. Es wurde überraschend festgestellt, dass selbst ABS, welches für eine hohe chemische Stabilität bekannt ist, bei hochfrequentierter Exposition mit der Hand und den darauf befindlichen Substanzen einem erhöhten Grad einer Oberflächenveränderung unterliegt.

Ausgehend von dieser Vorbetrachtung ist es die Aufgabe der vorliegenden Erfindung eine Fernbedienung mit einem Kunststoffgehäuse bereitzustellen, welches gegenüber herkömmlichem Polycarbonat oder PMMA höhere Bruchstabilität aufweist.

Optimalerweise kann diese Bruchstabilität durch weitere Merkmale ergänzt werden, welche vorteilhaft für das Anwendungsgebiet der Fernbedienungen sind.

Die vorliegende Erfindung löst die vorgenannte Aufgabe durch ein bruchstabile Fernbedienung mit den Merkmalen des Anspruchs 1.

Eine erfindungsgemäße bruchstabile elektrische Fernbedienung kann insbesondere als Fernbedienung zur Bedienung eines elektronischen Geräts ausgebildet sein. Es umfasst ein Kunststoffgehäuse mit einem Kunststoffplattensegment. Dieses Kunststoffplattensegment kann eben oder einfach oder mehrfach gewölbt ausgebildet sein. Das Kunststoffplattensegment weist ein Bedienfeld auf, welches zumindest ein Bedienelement zur Bedienung des elektronischen Gerätes, insbesondere zur Eingabe eines Steuerbefehls an das elektronische Gerät, aufweist. Das Bedienelement kann vorzugsweise als eines oder mehrere Tastenelemente ausgebildet sein und/oder als zumindest ein Steuerkreuz ausgebildet sein. Das Kunststoffplattensegment ist aus einem Kunststoffmaterial gebildet, insbesondere ausgeformt, welches eine Kerbschlagzähigkeit nach Charpy von mehr als 6,0 kJ/m², insbesondere 9,0 +/- 0,3 kJ/m², bei einer gekerbten Probe aufweist.

Erfindungsgemäß ist das Kunststoffmaterial als ein zumindest teilweise isosorbid-basiertes Polymer ausgebildet. Dadurch wird zusätzlich zur Kerbschlagzähigkeit auch eine erhöhte Resistenz gegenüber Schweiß, insbesondere Handschweiß, ausgebildet.

Vorteilhafte Ausgestaltungen der Erfindung sind Gegenstand der Unteransprüche.

Insbesondere und besonders vorteilhaft weist das Kunststoffplattensegment eine höhere Resistenz gegen Schweiß auf als ABS (Acrylnitril-Butadien-Styrol).

ABS gilt als Allround-Material unter den Kunststoffen. Es gilt als schlagfest, bruchstabil und resistent gegenüber wässrigen Chemikalien. Allerdings haben Versuche gezeigt, dass sich eine Änderung der Oberflächenerscheinung bei häufigem Kontakt mit Schweiß ergibt. Das Kunststoffplattensegment aus dem isosorbid-basierten Polymer weist demgegenüber geringere Ausprägung dieser Oberflächenerscheinung auf, was letztendlich das optische Erscheinungsbild der Fernbedienung geringer beeinflusst und dadurch der Bedarf zum Austausch der Fernbedienung durch den Endnutzer in geringerem Umfang auftritt.

Das Kunststoffmaterial kann als ein isosorbid-basierter Thermoplast, insbesondere als ein Polycarbonat, ausgebildet sein. Herkömmliche Polycarbonate werden beispielsweise aus Diphenylcarbonat und armomatischen Diolen gebildet. Isosorbid hingegen ist pflanzlichen Ursprungs und hinterlässt daher einen geringeren ökologischen Fußabdruck. Überdies unterliegt Isosorbid, anders als viele Aromaten, keiner besonderen Gefahrenklasse. R und S-Sätze zur besonderen Handhabung von Isosorbid liegen nicht vor, so dass ein Ausgasen von Monomeren im Fall einer Degradation der Polymere z.B. durch thermische Erwärmung, UV-Strahlung, Langzeit-Verwitterung und dergleichen unbedenklich ist.

Das Kunststoffmaterial weist vorzugsweise eine Bruchdehnung von mehr als 65%, insbesondere zwischen 70 - 130%, auf. Dadurch tendiert das Material nicht bei Einfluss eines mechanischen Schocks zum Brechen bzw. zu Rissen, sondern es verformt sich plastisch. Dadurch wird die Dichtigkeit des Gehäuseinnenraums mit der Elektronik gewährleistet.

Alternativ oder zusätzlich weist das Kunststoffmaterial ein Biegemodul von mehr als 1700 MPa auf. Dadurch reagiert das Material auf punktuelle mechanische Belastung durch eine Kombination aus plastischer und elastischer Verformung.

Das Kunststoffgehäuse weist vorteilhaft zumindest eine Oberschale und einer Unterschale auf. Besonders bevorzugt kann das Kunststoffgehäuse monolithisch ausgebildet sein, wobei die Oberschale und die Unterschale aus dem Kunststoffmaterial gebildet sind. Eine konkrete Realisierung eines monolithischen Aufbaus findet sich in der EP 3 393 753 B1, auf deren Aufbau im Rahmen der vorliegenden Erfindung vollumfänglich Bezug genommen wird.

Die einzelnen Bedienelemente, vorzugsweise sämtliche Bedienelemente, sind Teil des Kunststoffplattensegments, derart, dass das Kunststoffplattensegment monolithisch ausgebildet ist. Die Dichtigkeit in Kombination mit der verbesserten Bruchdehnung durch den Einsatz des isosorbidbasierten Polymers bringt besondere Vorteile im Fall des Einwirkens eines mechanischen Schocks mit sich, z.B. durch Fallenlassen der Fernbedienung, Handhabung durch Kleinkinder und dergleichen.

Das Bedienfeld kann zumindest zwei unterschiedliche Oberflächenrauhigkeiten aufweisen, wobei eines oder vorzugsweise alle Bedienelemente eine erste Oberflächenrauhigkeit aufweist und die Zwischenbereiche zwischen den Bedienelementen eine zweite Oberflächenrauhigkeit aufweist. Entsprechend muss das verwendete Kunststoffmaterial bearbeitbar und modifizierbar sein, ohne dass andere Oberflächeneigenschaften negativ, insbesondere degenerativ, beeinflusst werden und eine Bedruckbarkeit gewährleistet ist. Bei der Bedruckbarkeit eignen sich amorphe Kunststoffe besonders gut zur Ausbildung des Bedienfeldes. Somit ist die Verwendung eines isosorbidbasierten amorphen Thermoplasten für die Ausbildung des Bedienfeldes und insbesondere auch des Kunststoffplattensegments besonders bevorzugt.

Es ist von Vorteil, wenn das Kunststoffmaterial einen Lichttransmissionsgrad von mehr als 90% aufweist. Hochglanzoptiken sind eine wichtige Kaufentscheidung. Die End-of-Life-Spanne wird bei Fernbedienungen vom Endkunden bestimmt und richtet sich nicht nur nach der Integrität des Materials (Bruch- und Kratzresistenz), sondern auch nach dem optischen Erscheinungsbild der Fernbedienung. Eine matte abgenutzte Oberfläche kann ebenfalls ein Entsorgen bzw. eine Auswechslung der Fernbedienung auslösen. Dieses Merkmal gilt sowohl für transparentes als auch generell infrarot-durchlässiges Material.

Das Kunststoffmaterial kann alternativ dazu auch eine Einfärbung zur Beschriftung des Materials mittels Laser aufweisen.

Die Fernbedienung kann optional ein transparente Sensorfenster zum Austritt eines optischen Sensorsignals aufweisen, wobei das Sensorfenster aus dem Kunststoffmaterial gefertigt sein kann. Eine alternative Datenübermittlung kann über Bluetooth, insbesondere BLE, erfolgen. In diesem Fall ist das Sensorfenster nicht zwingend notwendig. Allerdings können auch beide Technologien ergänzend zueinander eingesetzt werden.

Alternativ kann die Fernbedienung eine Unterschale aus ABS-Material oder einem bisphenol-basierten Polycarbonat-Material oder dem zumindest teilweise isosorbid-basierten Polymer aufweisen.

Darüber hinaus kann das transparentes Sensorfenster der Unterschale zugeordnet sein. Ein entsprechendes Sensorfenster wird oft auch Diodenfenster genannt. Das Sensorfenster kann aus ABS-Material oder einem bisphenol-basierten Polycarbonat-Material oder auch aus dem zumindest teilweise isosorbid-basierten Polymer gefertigt sein.

Insbesondere die Oberschale der Fernbedienung kann vorteilhaft aus dem zumindest teilweise isosorbid-basierten Polymer gefertigt sein.

Das oder die Bedienelemente oder die Zwischenbereiche können somit vorteilhaft als ein Hochglanz-Erscheinungsbild realisiert sein. Aufgrund der Unanfälligkeit des isosorbidbasierten Kunststoffs gegenüber Fetten und Schweiß erfolgt auch bei einer Langzeitverwendung keine Abmattung der Oberfläche.

Das Kunststoffplattensegment kann auf der zum Bedienfeld entgegengesetzten Seite Steckelemente aufweisen, welche aufgrund der hohen Materialstabilität sehr stabil sind und bei Anwendung von Schrägkräften nicht abknicken bzw. abbrechen.

Die oben beschriebenen Eigenschaften, Merkmale und Vorteile dieser Erfindung sowie die Art und Weise wie diese erreicht werden, werden verständlicher im Zusammenhang mit der folgenden Beschreibung der Ausführungsbeispiele, die im Zusammenhang mit der Zeichnung näher erläutert werden. Es zeigen:
- Fig. 1: eine Fernbedienung in einer perspektivischen Ansicht auf die Bedienfläche, und
- Fig. 2: die perspektivische Rückansicht auf eine Oberschale der Fernbedienung; und
- Fig. 3: schematische Abbildung einer Messanordnung zur Ermittlung der Langzeitwirkungen von Schweiß auf die Kunststoffoberflächen eines isosorbidbasierten Materials im Vergleich zu ABS.

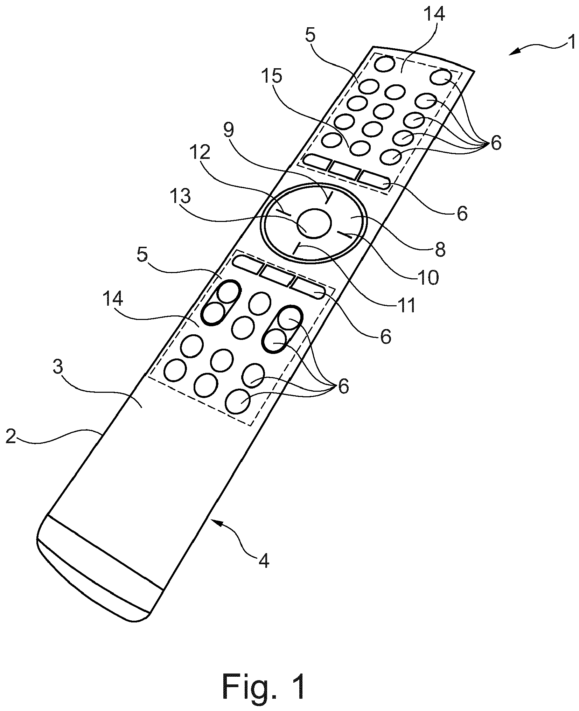

Die Figur ist eine rein schematische Darstellung. Tatsächliche geometrische Verhältnisse können von der Figur abweichen. Es wird auf Fig. 1 Bezug genommen, die eine Fernbedienung 1 zur Steuerung eines nicht weiter dargestellten elektronischen Gerätes, wie beispielsweise einem Multimediagerät, in einer perspektivischen Ansicht zeigt.

Die Fernbedienung 1 umfasst ein Kunststoffgehäuse 2, das aus einem ersten Gehäuseteil in Form einer Oberschale 3 und einem zweiten Gehäuseteil in Form einer Unterschale 4 zusammengesetzt ist, sowie zwei Tastenfelder 5 mit einer Vielzahl von Tastenelementen 6. Von den Tastenelementen 6 im Tastenfeld 5 sind in den Figuren der Übersichtlichkeit halber nicht alle mit einem Bezugszeichen versehen. Zwischen den beiden Tastenfeldern 5 ist ein Steuerkreuz 8 angeordnet, das ein erstes Tastenelement 9, ein zweites Tastenelement 10, ein drittes Tastenelement 11 und ein viertes Tastenelement 12 umfasst.

Die vier Tastenelemente 9 bis 12 sind umfänglich und im Abstand von 90° um eine Bestätigungstaste 13 angeordnet. Das Steuerkreuz 8 mit den vier Tastenelementen 9 bis 12 ist hier als kreisrunde Scheibe ausgebildet. Ferner sind auf der Fernbedienung 1 Rückmeldeelemente 14 in Form kleiner Lämpchen angeordnet, die in Abhängigkeit eines Tastendruckes auf der Fernbedienung 1 aufleuchten können. Mit der Fernbedienung 1 soll der Betrieb des beispielhaften Multimediagerätes gesteuert werden. Hierzu gibt ein Benutzer mittels der Tasten 5 auf der Oberschale 3 der Fernbedienung 1 Steuerbefehle als Informationen in die Fernbedienung 1 ein, die dann mittels eines nicht weiter gezeigten Übertragers an das zu steuernde elektronische Gerät übertragen werden. Ein derartiger Befehl kann beispielsweise als Richtungsbefehl über die Tastenelemente 9 bis 12 eingegeben werden, der dann die Bewegung eines Steuerelementes auf dem beispielhaften Multimediagerät in eine der vier möglichen Bewegungsrichtungen steuert.

Die Tastenelemente 6 der jeweiligen Tastenfelder, einzelne Tastenelemente 9-12 und auch der Steuerkranz 8 können gegenüber den Zwischenbereichen 14 zwischen den Tastenelementen, z.B. den Tastenelementen 6, hervorstehen oder können alternativ gegenüber den Zwischenbereichen 14 zurückgesetzt sein. Dabei können die Tastenelemente 6 und die Zwischenbereiche spaltlos ineinander übergehend, so dass die Oberschale eine durchgehende, vorzugsweise monolithisch-ausgebildete, Bedienoberfläche bildet. Die Fingerposition und damit die Zuordnung auf den Tastenelementen 6 kann sensorisch, beispielsweise kapazitiv, erfasst werden. Die Tastenelemente 6, 9-12, die Tastenfelder 5, der Steuerkranz 8 und alle weiteren Komponenten auf der Bedienoberfläche sind auf einem Kunststoffplattensegment 15 angeordnet, welche ebenfalls durchgehend, vorzugsweise monolithisch ausgebildet ist und die Teil der Oberschale 3 ist. Die mittlere Dicke des Kunststoffplattensegments 15 beträgt weniger als 3 mm, vorzugsweise weniger als 1,5 mm.

Das Kunststoffgehäuse 2 kann z.B. durch Spritzgießen hergestellt werden. Einzelne oder alle Tastenelemente 6, 9-12 oder auch der Steuerkranz 8 weisen eine Oberfläche auf, welche gegenüber den benachbarten Zwischenbereichen 14 eine andere Oberflächenrauhigkeit aufweisen. Es liegen somit eine erste und eine zweite Oberflächenrauhigkeit auf der Bedienoberfläche der Oberschale 3 vor, wobei die zweite Oberflächerauhigkeit größer ist als die erste Oberflächenrauhigkeit. Neben einer verbesserten visuellen Wahrnehmung der Tastenelemente und einer intuitiveren und damit schnelleren Bedienung ermöglicht die Differenzierung der Oberflächenrauhigkeit auch eine bessere Bedienung im Dunkeln. Es ist durchaus üblich und notwendig, einen Fernseher im Dunkeln anzuschalten und bei geringem Licht zu bedienen. Die differenzierte Oberflächenrauhigkeit ermöglicht eine Ertastbarkeit der richtigen Tasten, insbesondere bei bekannter Aufteilung des Tastenfeldes.

Eine Besonderheit der Oberschale 3 ist ihre besonders hohe Kerbschlagzähigkeit nach Charpy die bei einer Probe mit Kerbe mehr als 6 kJ/m² , insbesondere zwischen 8,8 bis 9,2 kJ/m² gemäß ISO 179-1eU in der aktuellen Fassung zum Zeitpunkt 09/2021 bei 23°C, x mm. Bei einer ungekerbten Probe ist der Einschlag ohne Bruch aufgrund der ausgeprägten Duktilität bzw. Biegsamkeit des Materials.

Eine weiterer Vorteil ist eine Bruchdehnung des Materials der Oberschale 3 von mehr als 65%, insbesondere zwischen 70 - 130%, nach ISO 527-1, -2 in der aktuellen Fassung zum Zeitpunkt 09/2021 bei 50 mm/min.

Dies verringert die Bruchtendenz bei mechanischem Schock, in einem Umfang, wie er im Haushalt häufig vorkommt.

Zugleich weist des Materials der Oberschale 3 bei 23 °C ein Biegemodul von mehr als 1700 MPa, vorzugsweise zwischen 1900-2300 MPa, nach ISO 527 in der aktuellen Fassung zum Zeitpunkt 09/2021.

Dadurch ist das Material nicht spröde, sondern weist zusätzlich zur Festigkeit auch eine entsprechende gewisse Flexibilität bei der sogenannten Dreipunktbelastung auf.

Fernbedienungen sollten zudem optisch ansprechend sein und einfach reinigbar, insbesondere mit geringem Einsatz von Lösungsmitteln. Das vorliegende Kunststoffgehäuse ist vorteilhaft resistent gegenüber Ethanol, dem häufigst in Reinigungsmittel eingesetzten organischen Lösungsmittel. Ein ansprechendes Erscheinungsbild der Oberschale 3 wird durch Verwendung eines Materials mit einem Lichttransmissionsgrad von mehr als 90%, gemäß ISO 13468-1,-2 bei 3 mm.

Eine weitere bevorzugte Eigenschaft liegt in der Resistenz der Oberschale 3 gegenüber Fettsäuren. Es ist bekannt, dass der menschliche Körper eine Fettschicht aufweist. Fettsäuren haben im häufigen Umgang mit Fernbedienungen einen Einfluss auf das Material des Kunststoffgehäuses. Fettsäuren können u.a. in Handcremes aber auch in Snacks wie Chips oder dergleichen enthalten sein.

Bei vielen üblichen Fernbedienungen wird als Hartplastik-Komponente ein übliches Polycarbonat eingesetzt, welche sich unter Einfluss von Fettsäuren eintrübt und seinen Glanz verliert. Dies ist beim Material im Rahmen der vorliegenden Erfindung nicht der Fall. Umgekehrt können matte Oberflächen unter Einfluss von Fettsäuren zunehmend einen fettigen Glanz erhalten.

Zumindest die Tastenelemente und/oder die Zwischenbereiche weisen vorzugsweise ein Hochglanz-Erscheinungsbild auf. Dies kann beispielsweise durch eine hochpolierte Fläche innerhalb des Spritzgusswerkzeugs realisiert werden oder durch eine Nachbearbeitung z.B. durch den Schritt des Präzisions-Blankpressens realisiert werden. Ein Hochglanz-Erscheinungsbild im Rahmen der vorliegenden Erfindung ermöglicht eine Spiegelung einer Lichtquelle, z.B. einer LED-Lichtleiste mit unterscheidbaren Einzelleuchtmittel auf der Oberfläche auf einer Weise, dass die Leuchtmittel auch im Spiegelbild der Fernbedienungsoberfläche unterscheidbar sind. Dieses Hochglanz-Erscheinungsbild entspricht der Oberfläche mit der vorgenannten ersten Oberflächenrauhigkeit. Demgegenüber ist die zweite Oberflächenrauhigkeit dergestalt ausgebildet, dass keine Spiegelung und ggf. auch nur eine geringe Lichtreflexion von den Flächen mit dieser zweiten Oberflächenrauhigkeit ausgeht.

All diese Randbedingungen, welche speziell für eine Fernbedienung von besonderem Vorteil sind, können durch die Verwendung eines isosorbid-basierten Polymer erreicht werden.

Besonders bevorzugt wird ein isosorbid-basiertes Thermoplast, insbesondere Polycarbonat, zur Herstellung des Bedienfeldes der Oberschale 3 eingesetzt. Ein weiterer Vorteil ist, dass auch eine sensorische Erfassung der Fingerposition möglich ist, ohne dass das Material des Bedienfeldes zu stark mit dem Sensorsignal interferiert.

Besonders bevorzugt ist die gesamte Oberschale 3 oder aber die gesamte Fernbedienung aus dem vorgenannten Material gebildet.

Das Material kann einen Farbstoff aufweisen und somit in einer Farbe, so z.B. schwarz, weiß o.ä. eingefärbt sein. Es ist von Vorteil, wenn die Fernbedienung 1 zusätzlich zum eingefärbten Bereich ein transparentes Signalfenster aufweist zur Übertragung eines optischen Signals. Dieses Signalfenster kann ebenfalls aus dem vorgenannten Material gefertigt sein. Aufgrund seiner exzellenten Transmissionswerte und bei einem bevorzugten Brechungsindex zwischen 1,49-1,53 kann eine gute Übermittlung eines optischen Signals von oder an ein Endgerät erfolgen.

Ein besonderer weiterer Vorteil ist die Reduzierung des biologischen Fußabdrucks, da Isosorbide in ausreichender Qualität zur Weiterverarbeitung zum Kunststoffmaterial des Kunststoffgehäuses 2 aus biologischen, insbesondere pflanzlichen, Ausgangsstoffen wie D-Sorbit gewonnen werden kann. Das D-Sorbit kann durch Dehydratisierung zum Isosorbid und durch Polymerisation (melt polymerization) letztendlich in Polycarbonat umgewandelt werden.

Einzelne Bauteile, insbesondere die Oberschale und die Unterschale können Steckelemente, Steckstifte und/oder Steckbuchsen, zur Verbindung miteinander und/oder mit Elektronikbauteilen, insbesondere mit einer Leiterplatte, aufweisen. Die Steckstifte weisen vorzugsweise einen Durchmesser von weniger als 2 mm auf. Gleiches gilt für die Wandstärke der Steckbuchsen. Diese filigranen Steckelemente 16 weisen trotz ihrer geringen Kontaktfläche mit der Kunststoffplatte 15 auf, welche sich auf der der Bedienfläche entgegengesetzten Seite des Kunststoffplattensegments 15 befindet, einen hervorragende Widerstandskraft gegen Abknicken bei angreifenden Schrägkräften auf.

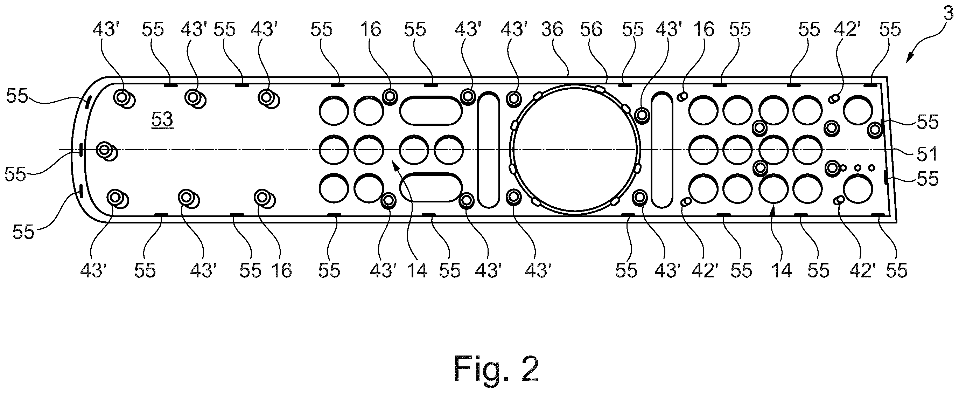

Die Steckelemente 16 sind als Steckstifte und/oder Steckbuchsen in Fig. 2 dargestellt.

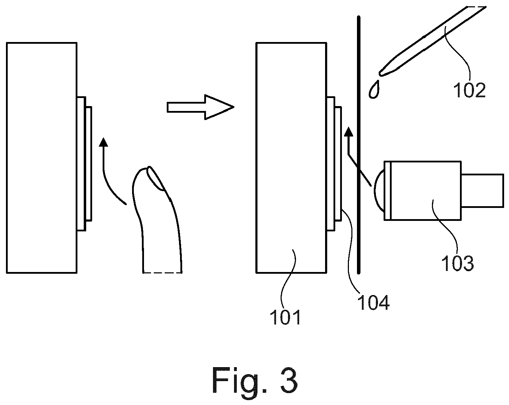

In Fig. 3 wird eine Messabfolge zur Simulation eines Handabriebs offenbart. Dabei wird das Abriebsprüfgerät Tribotouch 101 zur Simulation des Handabriebs eingesetzt. Die Prüfung erfolgt gemäß der europäischen Norm DIN EN 60068-2-70 / IEC 68-2-70.

Ziel ist es die zu untersuchende Oberfläche einer möglichst praxisgerecht nachempfundenen Handbetätigung auszusetzen. Zusätzlich zur mechanischen Belastung wird auch das chemische Umfeld mit künstlichem Schweiß 102 simuliert.

Ein in der Norm festgelegter Prüfstempel 103 wird schräg unter einem 45°Winkel auf die Oberfläche des Prüflings 104 auftreffen und dort einen geraden Reibweg von 1...4mm zurücklegen. Zwischen Prüfstempel und Prüfling muss sich ein spezielles Reibgewebe befinden. Zusätzlich wird das Reibgewebe mit einer Testsubstanz benetzt.

Reibweg: 4mm, Prüffrequenz: 2Hz, Testsubstanz: künstlicher Schweiß, Gewebevorschub alle 10.000 Zyklen 10 mm, Flüssigkeitszufuhr alle 1000 Zyklen 1ml, Schärfegrad 1N, 5N, und 10N.

Die Belastung mit 1N dauert sehr lange, deshalb wurde entschieden den Vergleich mit 5N und 10N durchzuführen.

Getestet wurde ABS-Material (Acrylnitril-Butadien-Styrol) und das aus Isosorbid hergestellte Polycarbonat bzw. das Polyisosorbidcarbonat.

Die Überprüfung erfolgte durch visuellen Vergleich der Oberflächen.

Das Polycarbonat-Material zeigt einen deutlich höheren Belastungsgrad - und damit eine höhere Belastbarkeit - beim simulierten Tastendruck mit künstlichem Schweiß als das standardmäßig verwendete ABS.

Somit konnte bewiesen werden, dass die Schweißresistenz des neuen Materials als ein wichtiger Faktor für das Gehäusematerial einer Fernbedienung deutlich höher ist als bei ABS. Hierfür kann insbesondere synthetischer Schweiß eingesetzt werden. Die Temperatur ist Raumtemperatur bei 25°C. Als mangelnde Resistenz ist ein Anlösen des Kunststoffs und damit verbunden ein Verlust des Glanzes der Kunststoffoberfläche nach dem Entfernen des Schweißes zu verstehen. Dabei wird ABS als Referenzsubstanz in stärkerem Maße und früher angelöst als der isosorbidbasierte Kunststoff.

### Bezugszeichenliste

- 1: Fernbedienung
- 2: Kunststoffgehäuse
- 3: Oberschale
- 4: Unterschale
- 5: Tastenfelder
- 6: Tastenelement

- 8: Steuerkreuz
- 9: Tastenelemente
- 10: Tastenelemente
- 11: Tastenelemente
- 12: Tastenelement
- 13: Bestätigungstaste
- 14: Zwischenbereiche
- 15: Kunststoffplattensegment
- 16: Steckelemente

## Patentansprüche

1. Bruchstabile elektrische Fernbedienung (1) zur Bedienung eines elektronischen Geräts umfassend ein Kunststoffgehäuse (2) mit einem Kunststoffplattensegment (15) mit einem Bedienfeld, welches zumindest ein Bedienelement, vorzugsweise Tastenelemente (6, 9-12) und/oder zumindest ein Steuerkreuz (8) zur Bedienung eines elektronischen Geräts aufweist,
wobei das Kunststoffplattensegment (15) aus einem Kunststoffmaterial gebildet ist, das eine Kerbschlagzähigkeit nach Charpy, insbesondere bei gekerbter Probe, von mehr als 6 kJ/m², insbesondere von 9,0 kJ/m² +/-0,3 kJ/m², aufweist,
**dadurch gekennzeichnet, dass** das Kunststoffmaterial als ein zumindest teilweise isosorbid-basiertes Polymer ausgebildet ist.

2. Fernbedienung nach Anspruch 1, **dadurch gekennzeichnet, dass** das Kunststoffplattensegment (15) eine höhere Resistenz gegen Schweiß aufweist als ABS (Acrylnitril-Butadien-Styrol).

3. Fernbedienung nach Anspruch 1 oder 2, **dadurch gekennzeichnet, dass** das Kunststoffmaterial als ein isosorbid-basierter Thermoplast, insbesondere als ein Polycarbonat, ausgebildet ist.

4. Fernbedienung nach einem der vorhergehenden Ansprüche, **dadurch gekennzeichnet, dass** das Kunststoffmaterial eine Bruchdehnung von mehr als 65%, insbesondere zwischen 70 - 130% und/oder ein Biegemodul von mehr als 1700 MPa aufweist.

5. Fernbedienung nach einem der vorhergehenden Ansprüche, **dadurch gekennzeichnet, dass** das Kunststoffgehäuse (2) zumindest eine Oberschale (3) und eine Unterschale (4) aufweist, und besonders bevorzugt monolithisch daraus gebildet ist, wobei die Oberschale (3) und die Unterschale (4) aus dem Kunststoffmaterial gebildet sind.

6. Fernbedienung nach einem der vorhergehenden Ansprüche,
**dadurch gekennzeichnet, dass** einzelne Bedienelemente, vorzugsweise sämtliche Bedienelemente, Teil des Kunststoffplattensegments (15) sind, derart, dass das Kunststoffplattensegment (15) monolithisch ausgebildet ist.

7. Fernbedienung nach Anspruch 6, **dadurch gekennzeichnet, dass** das Bedienfeld zumindest zwei unterschiedliche Oberflächenrauhigkeiten aufweist, wobei eines oder vorzugsweise alle Bedienelemente eine erste Oberflächenrauhigkeit aufweisen und die Zwischenbereiche (14) zwischen den Bedienelementen eine zweite Oberflächenrauhigkeit aufweisen.

8. Fernbedienung nach einem der vorhergehenden Ansprüche, **dadurch gekennzeichnet, dass** das Kunststoffmaterial eine Einfärbung zur Beschriftung des Materials mittels Laser aufweist.

9. Fernbedienung nach einem der vorhergehenden Ansprüche 1-4, 6, 7 oder 8, **dadurch gekennzeichnet, dass** die Fernbedienung eine Unterschale (4) aus ABS-Material oder einem bisphenol-basierten Polycarbonat-Material oder dem zumindest teilweise isosorbid-basierten Polymer aufweist.

10. Fernbedienung nach Anspruch 9, **dadurch gekennzeichnet, dass** die Unterschale (4) ein transparentes Sensorfenster, insbesondere ein Diodenfenster, aufweist, zum Austritt eines optischen Sensorsignals aufweist, wobei das Sensorfenster aus ABS-Material oder einem bisphenol-basierten Polycarbonat-Material oder dem zumindest teilweise isosorbid-basierten Polymer gefertigt ist.

11. Fernbedienung nach einem der vorhergehenden Ansprüche, **dadurch gekennzeichnet, dass** die Fernbedienung eine Oberschale (3) aufweist, die aus dem zumindest teilweise isosorbid-basierten Polymer gefertigt ist.

12. Fernbedienung nach einem der vorhergehenden Ansprüche, **dadurch gekennzeichnet, dass** zumindest das oder die Bedienelemente oder die Zwischenbereiche (14) ein Hochglanz-Erscheinungsbild aufweist.

13. Fernbedienung nach einem der vorhergehenden Ansprüche, **dadurch gekennzeichnet, dass** das Kunststoffplattensegment (15) auf der zum Bedienfeld entgegengesetzten Seite Steckelemente (16) aufweist.
